# EUROPÄISCHE PATENTANMELDUNG

(11) **EP 4 764 030 A2**
(43) Veröffentlichungstag der Anmeldung: **24.06.2026**
(21) Anmeldenummer: 25216499.1
(22) Anmeldetag: 18.11.2025
(51) Int. Cl.: C23C 18/16, B60R 21/26, F42B 3/12, H01R 4/02, H01R 13/03

(54) **ANORDNUNG MIT EINER ELEKTRISCHEN DURCHFÜHRUNG UND VERFAHREN ZU DEREN HERSTELLUNG**

(30) Priorität: 27.11.2024 DE 102024134966
(71) Anmelder: SCHOTT AG, 55122 Mainz (DE)
(72) Erfinder: ROEHRL, Johannes, 84028 Landshut (DE); GROHMANN, Lukas, 84028 Landshut (DE); ZOBEL, Christoph, 84028 Landshut (DE); WASTL, Daniela, 84028 Landshut (DE); SCHMIDBAUER, Sabine, 84028 Landshut (DE); SCHERZL, Phillip, 84028 Landshut (DE); LAINER, Johannes, 84028 Landshut (DE)
(74) Vertreter: Schott Corporate IP

(57) **Zusammenfassung**

Es wird eine Anordnung (1) mit zumindest einer elektrischen Durchführung (2) bereitgestellt umfassend einen Grundkörper (10) mit einer Öffnung (12), durch die ein elektrischer Leiter (16) hindurchgeführt ist und über ein Fixiermaterial (14) elektrisch isoliert vom Grundkörper (10) in der Öffnung (12) gehalten ist, wobei das Fixiermaterial (14) die Öffnung (12) verschließt und, wobei die nicht vom Fixiermaterial (14) bedeckte Oberfläche des elektrischen Leiters (16) vollständig mit einer ersten Beschichtung (20) versehen ist, die vom Fixiermaterial (14) bedeckte Oberfläche des elektrischen Leiters (16) frei von der ersten Beschichtung (20) ist und die nicht vom Fixiermaterial (14) bedeckte Oberfläche des Grundkörpers (10) frei von der ersten Beschichtung (20) ist und optional mit einer zweiten Beschichtung versehen ist, welche von der ersten Beschichtung (20) verschieden ist, oder die nicht vom Fixiermaterial (14) bedeckte Oberfläche des Grundkörpers (10) vollständig mit der ersten Beschichtung (20) versehen ist, die vom Fixiermaterial (14) bedeckte Oberfläche des Grundkörpers (10) frei von der ersten Beschichtung (20) ist und die nicht vom Fixiermaterial (14) bedeckte Oberfläche des elektrischen Leiters (16) frei von der ersten Beschichtung ist (20) und optional mit einer zweiten Beschichtung versehen ist, welche von der ersten Beschichtung (20) verschieden ist. Die erste Beschichtung (20) weist eine oder mehrere Schichten auf und zumindest eine äußerste Schicht (22) der ersten Beschichtung (20) ist eine außenstromlos abgeschiedene Schicht aus einem ersten Beschichtungsmaterial.

## Beschreibung

Die Erfindung betrifft eine Anordnung mit zumindest einer elektrischen Durchführung umfassend einen Grundkörper mit zumindest einer Öffnung, durch die ein elektrischer Leiter hindurchgeführt und über ein Fixiermaterial elektrisch isoliert vom Grundkörper in der Öffnung gehalten ist, wobei das Fixiermaterial die Öffnung verschließt. Dabei ist der elektrische Leiter und/oder der Grundkörper mit einer Beschichtung versehen. Ferner betrifft die Erfindung ein Verfahren zur Herstellung einer solchen Anordnung.

### Stand der Technik

Anordnungen mit einer elektrischen Durchführung werden in verschiedenen Bereichen eingesetzt, beispielsweise in Anzündern für Airbags, in Gehäusen für elektronische oder optoelektronische Komponenten, und in elektrisch angetriebenen Kompressoren. Die Anordnungen können dabei eine oder mehrere elektrische Durchführungen enthalten, wobei eine elektrische Durchführung einen Grundkörper und einen durch eine Öffnung im Grundkörper hindurchgeführten elektrischen Leiter umfasst. Der elektrische Leiter wird dabei über ein elektrisch isolierendes Fixiermaterial in der Öffnung gehalten und die Öffnung wird über das Fixiermaterial dicht verschlossen. Derartige elektrische Durchführungen werden auch als Fixiermaterial- Metall-Durchführungen bezeichnet.

Typische Fixiermaterial- Metall-Durchführungen sind derart aufgebaut, dass elektrische Leiter, insbesondere Metallstifte oder Anschlussstifte, in einen vorgeformten Pressling eingeschmolzen werden, wobei der Pressling zusammen mit dem Leiter in den Grundkörper eingebracht wird. Über eine Temperaturbehandlung wird aus dem Pressling das Fixiermaterial erhalten.

Eine solche Fixiermaterial- Metall-Durchführung zur Verwendung in Anzündern für Airbags ist aus DE 10 2014 219 124 A1 bekannt. Zur Vermeidung von Oxidation oder zur Funktionalisierung der Oberfläche der durchgeführten elektrischen Leiter, ist vorgesehen, diese über galvanische Prozesse mit Gold zu beschichten.

Bei dem galvanischen Beschichten werden die zu beschichtenden Komponenten, hier die elektrischen Leiter der elektrischen Durchführung, elektrisch kontaktiert und in eine Beschichtungslösung eingetaucht. Durch Steuern der Stromstärke und der Dauer kann die Stärke der erhaltenen Beschichtung eingestellt werden. Der durch das Fixiermaterial elektrisch von den Leitern isolierte Grundkörper wird dabei nicht beschichtet.

Nachteilig an dem bekannten galvanischen Beschichten ist, dass die zu beschichtenden elektrischen Leiter der Durchführungen jeweils einzeln elektrisch kontaktiert werden müssen, was das Verfahren langsam und aufwändig macht. Des Weiteren entsteht üblicherweise an der Kontaktstelle, an der der elektrische Leiter elektrisch kontaktiert wird, eine Fehlstelle in der Beschichtung, welche ein Ausgangspunkt für Korrosion sein kann.

Es ist somit eine Aufgabe der Erfindung eine Anordnung bereitzustellen, bei der selektiv nur ausgewählte Komponenten beschichtet werden, wobei deren Beschichtung frei von Fehlstellen ist und wobei die Beschichtung sich einfach und ohne elektrische Kontaktierung der einzelnen elektrischen Leiter herstellen lässt.

### Offenbarung der Erfindung

Es wird eine Anordnung vorgeschlagen, wobei die Anordnung zumindest eine elektrische Durchführung aufweist, umfassend einen Grundkörper mit einer Öffnung, durch die ein elektrischer Leiter hindurchgeführt und über ein Fixiermaterial elektrisch isoliert in der Öffnung gehalten ist, wobei das Fixiermaterial die Öffnung verschließt und wobei sowohl der elektrische Leiter als auch der Grundkörper metallische Komponenten sind. Die nicht vom Fixiermaterial bedeckte Oberfläche des elektrischen Leiters ist vollständig mit einer ersten Beschichtung versehen, die vom Fixiermaterial bedeckte Oberfläche des elektrischen Leiters ist frei von der ersten Beschichtung und die nicht vom Fixiermaterial bedeckte Oberfläche des Grundkörpers ist frei von der ersten Beschichtung und ist optional mit einer zweiten Beschichtung versehen, welche von der ersten Beschichtung verschieden ist, oder
die nicht vom Fixiermaterial bedeckte Oberfläche des Grundkörpers ist vollständig mit der ersten Beschichtung versehen, die vom Fixiermaterial bedeckte Oberfläche des Grundkörpers ist frei von der ersten Beschichtung und die nicht vom Fixiermaterial bedeckte Oberfläche des elektrischen Leiters ist frei von der ersten Beschichtung und ist optional mit einer zweiten Beschichtung versehen, welche von der ersten Beschichtung verschieden ist.

Ferner ist vorgesehen, dass die erste Beschichtung eine oder mehrere Schichten aufweist und zumindest eine äußerste Schicht der ersten Beschichtung eine außenstromlos abgeschiedene Schicht aus einem ersten Beschichtungsmaterial ist. Weist die erste Beschichtung nur eine einzige Schicht auf, so ist diese auch die äußerste Schicht.

Die elektrische Durchführung weist somit zumindest zwei metallische Komponenten auf, einen elektrischen Leiter und einen Grundkörper, wobei nach dem Ausbilden der elektrischen Durchführung, bei der der elektrische Leiter durch eine Öffnung im Grundkörper hindurchgeführt ist und über ein Fixiermaterial gehalten ist, die erste Beschichtung selektiv nur auf eine der beiden Komponenten aufgebracht wurde. Die jeweils andere Komponente bleibt frei von der ersten Beschichtung.

Die außenstromlos abgeschiedene äußerste Schicht der ersten Beschichtung wird erhalten, indem eine Rohanordnung mit der zumindest einen elektrischen Durchführung in ein Bad mit einer Beschichtungslösung, insbesondere einer Elektrolytlösung, eingetaucht wird. Ohne externe Stromzufuhr scheidet sich aus dem Bad das erste Beschichtungsmaterial selektiv auf der nicht vom Fixiermaterial bedeckten und damit freiliegenden Oberfläche des elektrischen Leiters bzw. des Grundkörpers ab, wobei die Oberfläche der jeweils anderen Komponente frei von dem ersten Beschichtungsmaterial bleibt. Für dieses selektive Abscheiden werden die Metallmaterialien des Grundkörpers und des elektrischen Leiters bzw. das Material von deren Oberflächen derart ausgewählt, dass nur eine dieser Komponenten bei der außenstromlosen Abscheidung beschichtet wird und die jeweilige andere Komponente unbeschichtet bleibt.

Die Anordnung kann mehr als eine elektrische Durchführung umfassen, wobei sich mehrere elektrische Durchführungen einen gemeinsamen Grundkörper teilen können. Die elektrische Durchführung ist bevorzugt als Fixiermaterial- Metall-Durchführung ausgebildet. Eine solche Fixiermaterial- Metall-Durchführung kann beispielsweise erhalten werden, indem ein Fixiermaterialrohling, beispielsweise in Form eines Rohrabschnitts aus einem Glas oder eines Presslings aus einem Glaspulver, bereitgestellt wird und zusammen mit dem elektrischen Leiter in eine Öffnung des Grundkörpers eingesetzt wird. Durch eine Temperaturbehandlung schmilzt der Fixiermaterialrohling und bildet das Fixiermaterial aus. Dabei dichtet das Fixiermaterial gegen die Wandung der Öffnung und den elektrischen Leiter ab. Die erste Beschichtung wird nach dem Ausbilden der elektrischen Durchführung aufgebracht und bedeckt entsprechend nur die Oberflächen des elektrischen Leiters bzw. des Grundkörpers, welche nicht von dem Fixiermaterial überdeckt sind.

Das nachträgliche Aufbringen der ersten Beschichtung erlaubt es, für die erste Beschichtung Materialien auszuwählen, welche nicht gegen die hohen Temperaturen bei der Ausbildung der elektrischen Durchführung beständig sind. Derartige Beschichtungsmaterialien können schmelzen oder bei den erhöhten Temperaturen kann es zu (Inter-)Diffusion mit darunterliegenden Materialien bzw. mit dem Material des elektrischen Leiters bzw. des Grundkörpers kommen. Dadurch kann die Beschichtung ihre Funktion verlieren. Ein Beispiel hierfür sind Goldschichten zur Verbesserung eines elektrischen Kontakts mit dem elektrischen Leiter oder zum Schutz vor Oxidation.

Die Selektivität des verwendeten außenstromlosen Beschichtungsverfahrens wird hierbei ausgenutzt, um nur ausgewählte Teile bzw. Komponenten der Anordnung mit der ersten Beschichtung bzw. der äußersten Schicht der ersten Beschichtung zu versehen. Dies ist z.B. bei einer Goldbeschichtung von Vorteil, welche beispielsweise zum Oxidationsschutz und zur Verbesserung einer elektrischen Verbindung zwischen einem elektrischen Kontakt und dem elektrischen Leiter dienen kann. Zum einen wird Material eingespart, zum anderen behält die nicht beschichtete Komponente ihre Eigenschaften.

Ein Merkmal der außenstromlosen Abscheidung ist die hohe Gleichmäßigkeit der erhaltenen Schichtstärke der abgeschiedenen Schicht und die Möglichkeit, die vom Fixiermaterial nicht überdeckte Oberfläche der jeweiligen Komponente vollständig zu beschichten, da keine Fehlstellen durch eine elektrische Kontaktierung vorliegen. Im Gegensatz dazu ist die lokale Schichtstärke bei galvanischer Abscheidung von der lokalen elektrischen Feldstärke bzw. der lokal vorliegenden kathodischen Stromdichte abhängig, welche nicht gleichmäßig ist, sondern insbesondere von der Geometrie und Orientierung der Komponente im Elektrolyten beeinflusst ist. An Stellen der Komponente, die eine starke Krümmung bzw. Ecken oder Kanten aufweisen, ist die lokale Stromstärke abhängig davon, ob die Krümmung konvex oder konkav ist, erhöht oder verringert, was sich in einer entsprechenden Variation der Stärke der Beschichtung niederschlägt. So ist beispielsweise im Bereich von Außenkanten, wie beispielsweise an den Enden der Leiter, die elektrische Feldstärke bzw. die Stromdichte lokal erhöht, so dass dort bei der galvanischen Beschichtung mehr Material abgeschieden wird als in Bereichen, in denen die Oberfläche flacher ist. Entsprechend weisen galvanisch beschichtete Leiter in der Regel an deren Enden eine höhere Schichtstärke auf als beispielsweise an den vom Ende beabstandeten Bereichen. Des Weiteren weisen galvanisch beschichtete Leiter bzw. Grundkörper zumindest eine Fehlstelle in der Beschichtung auf, an der die Komponente für die galvanische Abscheidung elektrisch kontaktiert wurde. Im Gegensatz dazu weist eine außenstromlos abgeschiedene Beschichtung keine solche Fehlstelle auf. Die Beschichtung kann vollständig und geschlossen ausgebildet sein, wobei bei dünnen Schichten mit Dicken im Bereich einiger zehn Nanometer bis wenige Mikrometer Poren nicht vollständig vermieden werden können und im Rahmen dieser Beschreibung auch Schichten mit solchen kleinen Poren noch als vollständige, geschlossene Schichten angesehen werden.

Die außenstromlose Abscheidung wird hier in zwei Gruppen eingeteilt: Abscheidung durch Ionen- oder Ladungsaustausch (Zementation, Sudabscheidung; Substrat selbst ist Reduktionsmittel), und autokatalytische Abscheidung (chemische Abscheidung; Reduktionsmittel ist in der Beschichtungslösung enthalten). Eigenkatalytisch wirkende Werkstoffe leiten das Abscheiden der Schicht selbst ein (im Fall von Nickel als abzuscheidendes Material sind das beispielsweise Co, Ni, Ru, Rh, Pd, Os, Ir und Pt). Fremdkatalytisch wirkende Werkstoffe wirken nicht selbst als Katalysator und werden erst durch die Bekeimung mit einem eigenkatalytisch wirkenden Werkstoff katalytisch wirksam. Bei den Werkstoffen, die in der Elektrolytlösung unedler als das abzuscheidende Material sind, findet zunächst eine Abscheidung von Keimen des abzuscheidenden Materials mittels Zementation statt. Für den Fall einer Nickelbeschichtung scheiden sich zuerst Ni Keime durch Ladungsaustausch (Zementation) ab. Zu diesen unedleren Werkstoffen zählen im Fall von Nickel als abzuscheidendes Material z.B. Be oder Fe. Dadurch lassen sich auch diese Werkstoffe außenstromlos beschichten.

Zementation meint hier insbesondere, dass Keime, welche katalytisch wirksam sind, vor dem Beschichten oder zu Beginn des Beschichtens auf die zu beschichtende Oberfläche aufgebracht werden. Werkstoffe, die in der Elektrolytlösung edler als das abzuscheidende Material sind, und nicht eigenkatalytisch wirksam sind, und im Falle von Nickel somit nicht mittels Zementation von Ni Keimen katalytisch wirksam werden, können beispielsweise mit einem kurzen kathodischen Strompuls in der Beschichtungslösung und dem damit verbundenen Abscheiden von Ni Keimen, dem Abscheiden einer Nickel-Strike Schicht oder dem Aufbringen von anderen katalytisch wirksamen Keimen auf der Oberfläche katalytisch wirksam gemacht werden.

Der mit der ersten Beschichtung versehene elektrische Leiter bzw. der mit der ersten Beschichtung versehene Grundkörper besteht vollständig oder zumindest an seiner Oberfläche aus einem ersten Metallmaterial, welches außenstromlos mit dem ersten Beschichtungsmaterial beschichtbar ist, oder weist eine Zwischenschicht auf, die aus dem ersten Metallmaterial besteht, welches außenstromlos mit dem ersten Beschichtungsmaterial beschichtbar ist. Diese Zwischenschicht kann bei geeigneter Materialauswahl ebenfalls außenstromlos abgeschieden sein oder kann alternativ mit einem anderen Beschichtungsverfahren erzeugt worden sein.

Das erste Metallmaterial ist bevorzugt so gewählt, dass dessen Oberfläche katalytisch für das außenstromlose Abscheiden wirksam ist oder durch Aufbringen von katalytisch wirksamen Keimen katalytisch wirksam gemacht ist. Bevorzugte Beispiele für geeignete erste Metallmaterialien sind Ag, Ag-Legierungen, Cu, Cu-Legierungen, Ni, Ni-Legierungen ohne Passivschicht, Platinmetalle und Platinmetalllegierungen, Fe, Stähle ohne Passivschicht, Co und Co-Legierungen ohne Passivschicht, Kovar, Mn und Mn-Legierungen ohne Passivschicht, Zn, Zn-Legierungen, Sn und Sn-Legierungen.

Als Passivschicht wird hierbei insbesondere eine sich an der Oberfläche des jeweiligen Materials ausbildende Oxidschicht verstanden, welche die außenstromlose Abscheidung verhindert und somit in Bezug auf die außenstromlose Abscheidung des ersten Beschichtungsmaterials passiv ist. Bei nichtrostendem Stahl bilden beispielsweise Chrom und Sauerstoff an der Oberfläche des Materials eine Chromoxidschicht aus, welche in Bezug auf die außenstromlose Beschichtung passiv ist und damit nicht mit dem ersten Beschichtungsmaterial beschichtbar ist. Sollen Materialien, welche derartige Passivschichten ausbilden, beschichtet werden, muss die Passivschicht vor dem außenstromlosen Beschichten entfernt werden, so dass die Oberfläche frei von einer derartigen Passivschicht bzw. der Oxidschicht ist.

Der von der ersten Beschichtung freie Grundkörper bzw. der von der ersten Beschichtung freie elektrische Leiter besteht vollständig oder zumindest an seiner Oberfläche aus einem zweiten Metallmaterial, welches nicht außenstromlos mit dem ersten Beschichtungsmaterial beschichtbar ist, oder weist eine zweite Beschichtung auf, deren einzige oder deren äußerste Schicht aus dem zweiten Metallmaterial besteht, welches nicht außenstromlos mit dem ersten Beschichtungsmaterial beschichtbar ist.

Das zweite Metallmaterial ist entsprechend so gewählt, dass dessen Oberfläche in Bezug auf die Beschichtungslösung passiv ist. Bevorzugte Beispiele für geeignete zweite Metallmaterialien sind nichtrostende Stähle mit einer Passiv-Schicht, wie z.B. eine Chromoxidschicht, Nickellegierungen, mit einer Passiv-Schicht, insbesondere Nickellegierungen mit Mo, Cu und/oder Cr. Des Weiteren sind die Metalle Ti, Mo, W, Al, Nb, Cr, Zr, Hf, V, Ta und deren Legierungen geeignet.

Im Fall eines Metallmaterials, welches eine Passivschicht ausbildet, kann diese Passivschicht als eine Art zweite Beschichtung aufgefasst werden. Da sich diese Passivschicht natürlicherweise auf diesen Metallmaterialien ausbildet, wird diese Passivschicht im Rahmen dieser Beschreibung vereinfachend als Teil des zweiten Metallmaterials angesehen.

Das erste Beschichtungsmaterial ist bevorzugt ausgewählt aus Nickel mit Anteilen an Phosphor (NiP), Nickel mit Anteilen an Bor (NiB), Ni, Cu, Sn, Ag, Palladium mit Anteilen an Phosphor (PdP), Pd und Au.

Chemisches Abscheiden von Nickel kann beispielsweise als Nickel-Phosphor oder Nickel-Bor Schicht erfolgen. In beiden Fällen wird die Anordnung in eine wässrige Beschichtungslösung eingetaucht, welche unter anderem ein Nickelsalz und ein Reduktionsmittel enthält. Im Fall einer Nickel-Phosphor Beschichtung wird als Reduktionsmittel beispielsweise ein Phosphinat eingesetzt, im Fall einer Nickel-Bor Schicht üblicherweise ein Borhydrid. Der Beschichtungsvorgang läuft autokatalytisch ab, wobei entsprechend nur diejenigen Oberflächen mit Nickel bzw. der entsprechenden Nickellegierung beschichtet werden, welche katalytisch wirksam sind oder beispielsweise mittels Zementation katalytisch wirksam gemacht wurden.

Außenstromloses Abscheiden von Kupfer (Cu) kann ebenfalls chemisch erfolgen. Voraussetzung für die Abscheidung ist ein erstes Metallmaterial, welches eigenkatalytisch wirksam ist, oder welches unedler als Cu ist. In letzterem Fall erfolgt anfänglich eine Cu-Bekeimung durch Zementation.

Ein außenstromloses Abscheiden von Silber (Ag) kann chemisch als auch mittels Zementation (Sudabscheidung, Immersion Silver) erfolgen. Voraussetzung für die chemische Abscheidung ist ein erstes Metallmaterial, welches eigenkatalytisch wirksam ist, oder welches unedler als Ag ist. In letzterem Fall erfolgt anfänglich eine Ag-Bekeimung durch Zementation.

Außenstromloses Abscheiden von Zinn (Sn) kann ebenfalls chemisch oder durch Zementation erfolgen. Voraussetzung für die Abscheidung ist ein erstes Metallmaterial, welches eigenkatalytisch wirksam ist, oder welches unedler als Sn ist.

Ein außenstromloses Abscheiden von Palladium kann chemisch, beispielsweise als Palladium-Phosphor-Schicht, als auch mittels Zementation (Sudabscheidung, Immersion Palladium) erfolgen. Voraussetzung für die Abscheidung ist ein erstes Metallmaterial, welches eigenkatalytisch wirksam ist, oder welches unedler als Pd ist. In letzterem Fall erfolgt anfänglich eine Pd-Bekeimung durch Zementation.

Ein außenstromloses Abscheiden von Gold (Au) kann chemisch (autokatalytisch), mittels Zementation (Sudabscheidung, Immersion Gold) als auch semi-autokatalytisch erfolgen. Voraussetzung für die chemische Abscheidung ist ein erstes Metallmaterial, welches eigenkatalytisch wirksam ist, oder welches unedler als Au ist. In letzterem Fall erfolgt anfänglich eine Au-Bekeimung durch Zementation. Die semi-autokatalytische Abscheidung stellt eine Mischform der reinen Sud- und autokatalytischen Abscheidungen dar. Durch dieses Verfahren wird beispielsweise bei einem chemisch Nickel/Sudgold-Schichtsystem der bei der Sudabscheidung verfahrensbedingte korrosive Angriff auf die darunterliegende chemisch Nickel Schicht durch den anteiligen autokatalytischen Reaktionsmechanismus reduziert.

Bevorzugt umfasst die erste Beschichtung mehrere Schichten. Dabei wird bevorzugt eine Nickelschicht, beispielsweise eine Nickel-Phosphor-Schicht als erste Schicht eingesetzt. Die Nickelschicht ist so geartet, dass weitere Schichten der Beschichtung über außenstromlose Prozesse abgeschieden werden können. Die Nickelschicht kann als Korrosionsschutz dienen.

In einem Beispiel werden genau zwei Schichten eingesetzt, wobei die erste Schicht eine Nickelschicht oder Nickellegierungsschicht ist und die zweite Schicht eine Goldschicht ist. Diese Schichtkombination ist vorteilhaft als Kontaktfläche zum Löten und kann beispielsweise zum Aluminiumdrahtbonden verwendet werden.

In einem weiteren Beispiel werden genau drei Schichten eingesetzt, wobei die erste Schicht eine Nickelschicht oder Nickellegierungsschicht ist, die zweite Schicht eine Palladiumschicht oder Palladiumlegierungsschicht ist und die dritte Schicht eine Gold-schicht ist. Diese Schichtkombination ist vorteilhaft als Kontaktfläche zum Löten und kann beispielsweise zum Golddrahtbonden verwendet werden.

Bevorzugt werden alle elektrischen Leiter aus demselben Metallmaterial gewählt bzw. deren Oberflächen aus demselben Metallmaterial gewählt, so dass alle elektrischen Leiter entweder außenstromlos beschichtbar oder nicht außenstromlos beschichtbar sind. Alternativ dazu ist es denkbar, einen oder mehrere elektrische Leiter aus einem anderen Metallmaterial zu wählen bzw. deren Oberfläche aus einem anderen Metallmaterial zu wählen, welches nicht außenstromlos beschichtbar ist. Hierdurch kann erreicht werden, dass selektiv nur ausgewählte elektrische Leiter mit der ersten Beschichtung versehen werden und andere, nicht ausgewählte elektrische Leiter frei von der ersten Beschichtung bleiben.

Das Material des nicht außenstromlos beschichtbaren Grundkörpers ist bevorzugt ein austenitischer nichtrostender Stahl. An der Oberfläche des nichtrostenden Stahls ist dabei eine Passivschicht vorhanden, welche nicht mit dem ersten Beschichtungsmaterial außenstromlos beschichtbar ist.

Als Material für den außenstromlos beschichtbaren elektrischen Leiter ist insbesondere eine Eisen-Nickel Legierung wie NiFe45 geeignet. Weitere gut geeignete Materialien für einen außenstromlos beschichtbaren Leiter umfassen Nickel-Cobalt Legierungen wie NiCo2918, Drähte mit einer Seele aus Kupfer und einem Mantel aus einer Nickel-EisenLegierung.

Das Fixiermaterial ist bevorzugt ausgewählt aus einem Glas, einer Glaskeramik oder einer Keramik. Zur Bildung eines Presslings bzw. eines Fixiermaterialrohlings kann das Ausgangsmaterial in Pulverform zusammen mit einem Bindemittel zu einem Fixiermaterialrohling geformt werden. Der Fixiermaterialrohling kann aber z.B. auch als Rohrabschnitt bereitgestellt werden.

Die gebildete Fixiermaterial-Metall-Durchführung ist bevorzugt hermetisch dicht ausgeführt. Als hermetisch dicht wird hierbei eine Durchführung verstanden, die eine Heliumleckrate von weniger als 1·10⁻⁸ mbar·l/s aufweist.

Die Anordnung kann zusätzlich einen oder mehrere Masseleiter umfassen. Ein solcher Masseleiter ist elektrisch leitfähig mit dem Grundkörper verbunden und an diesem befestigt, beispielsweise mittels Löten oder Schweißen.

Der Masseleiter kann je nach Ausführungsform an seiner Oberfläche aus einem Metallmaterial bestehen oder an seiner Oberfläche ein Metallmaterial aufweisen welches außenstromlos beschichtbar ist oder nicht außenstromlos beschichtbar ist. Bevorzugt wird ein außenstromlos beschichtbares Metallmaterial gewählt, wenn auch das Metallmaterial des Grundkörpers ein außenstromlos beschichtbares Material ist und umgekehrt wird bevorzugt ein nicht außenstromlos beschichtbares Metallmaterial gewählt, wenn das Metallmaterial des Grundkörpers ebenfalls nicht außenstromlos beschichtbar ist.

Ein weiterer Aspekt der Erfindung ist es, ein Verfahren zur Herstellung der hierin beschriebenen Anordnungen bereitzustellen.

In einem ersten Schritt des Verfahrens wird ein elektrischer Leiter bereitgestellt, der an seiner Oberfläche ein erstes Metallmaterial aufweist oder der aus dem ersten Metallmaterial besteht und es wird ein Grundkörper mit einer Öffnung bereitgestellt, der an seiner Oberfläche ein zweites Metallmaterial aufweist oder aus dem zweiten Metallmaterial besteht. Alternativ dazu wird ein Grundkörper mit einer Öffnung bereitgestellt, der an seiner Oberfläche ein erstes Metallmaterial aufweist oder aus dem ersten Metallmaterial besteht und es wird ein elektrischer Leiter bereitgestellt, der an seiner Oberfläche ein zweites Metallmaterial aufweist oder aus dem zweiten Metallmaterial besteht. Ferner wird ein Fixiermaterialrohling bereitgestellt.

Nachfolgend erfolgt ein Einsetzen des elektrischen Leiters und des Fixiermaterialrohlings in die Öffnung des Grundkörpers. Anschließend erfolgt ein Einbetten des elektrischen Leiters und Ausbilden des Fixiermaterials durch eine Temperaturbehandlung. Dabei wird eine elektrische Durchführung ausgebildet und eine Rohanordnung erhalten.

Nach dem Erhalten der Rohanordnung erfolgt ein außenstromloses Abscheiden einer Schicht aus einem ersten Beschichtungsmaterial auf freiliegende Oberflächen des elektrischen Leiters bzw. auf freiliegende Oberflächen des Grundkörpers durch Eintauchen der Rohanordnung in eine Beschichtungslösung. Sofern erforderlich kann die Rohanordnung vor dem außenstromlosen Beschichten vorbehandelt werden. Das kann ein Reinigen der Oberflächen umfassen.

Optional kann der Beschichtungsschritt durch Eintauchen der Rohanordnung in eine oder mehrere weitere Beschichtungslösungen wiederholt werden, so dass die durch den oder die Beschichtungsschritte erhaltene erste Beschichtung eine oder mehrere Schichten umfasst. Die jeweils zuletzt erhaltene Schicht der ersten Beschichtung ist dabei die äußerste Schicht.

### Beispiel

Es wurde zunächst eine Rohanordnung mit einer elektrischen Durchführung hergestellt. Für das Herstellen der Rohanordnung wurde ein Grundkörper aus einem austenitischen nichtrostenden Stahl mit der Materialnummer 1.4404 und ein elektrischer Leiter aus NiFe45 verwendet. Zum Ausbilden des Fixiermaterials wurde ein Glaspressling als Fixiermaterialrohling verwendet. Der elektrische Leiter, und der Glaspressling wurden in eine Öffnung des Grundkörpers eingesetzt und in einem Ofen eingeschmolzen.

Zunächst erfolgte ein Reinigen der Oberflächen der Rohanordnung, um diese zu entfetten und um Oxide von der Oberfläche des elektrischen Leiters zu entfernen, welche eine Passivschicht darstellen würden.

Anschließend wurde die Rohanordnung in einen außenstromlos abscheidenden Nickelelektrolyten eingebracht, um eine Nickel-Phosphor-Schicht abzuscheiden. Nach Erhalt der gewünschten Schichtdicke wurde die Rohanordnung in einem Wasserbad gespült und in ein Bad mit einem Sudgold-Elektrolyten eingebracht.

Durch die entsprechende Auswahl der Metallmaterialien für den elektrischen Leiter und den Grundkörper wurden Anordnungen erhalten, bei denen selektiv lediglich die elektrischen Leiter mit einer zweischichtigen Beschichtung versehen wurden, welche eine Zwischenschicht aus Nickel-Phosphor und eine äußerste Schicht aus Gold aufweist.

Vorteilhafterweise müssen bei der vorgeschlagenen selektiven außenstromlosen Beschichtung die einzelnen elektrischen Leiter der Anordnungen nicht mit einem elektrischen Anschluss kontaktiert werden, um diese galvanisch beschichten zu können. Die einzelnen Rohanordnungen können einfach in die Beschichtungslösung bzw. den Elektrolyten eingebracht werden und gezielt deren elektrischen Leiter beschichtet werden. Dies erlaubt eine schnelle und einfache Beschichtung einer großen Anzahl von Anordnungen. Zudem weist die vorgeschlagene außenstromlose Beschichtung den Vorteil auf, dass die erreichten Schichtstärken gleichmäßig sind und insbesondere nicht an den Enden der Leiter eine höhere Schichtstärke vorliegt. Des Weiteren weist die außenstromlos abgeschiedene Beschichtung keine Fehlstellen auf, wie diese üblicherweise an der Kontaktstelle mit dem elektrischen Anschluss auftreten. Derartige Fehlstellen sollten vermieden werden, um beispielsweise Korrosion zu vermeiden. Zudem ist das Verfahren selektiv, so dass der Grundkörper frei von der Beschichtung bleibt und daher die Eigenschaften des Materials des Grundkörpers erhalten bleiben.

Die Erfindung soll nachfolgend anhand der Figuren und ohne Beschränkung hierauf eingehender beschrieben werden. Gleiche Bezugszeichen bezeichnen dabei gleiche oder ähnliche Elemente.

Es zeigen:
Fig. 1: eine Anordnung mit drei elektrischen Durchführungen, bei denen die Leiter selektiv beschichtet sind,
Fig. 2 eine Anordnung mit drei elektrischen Durchführungen, bei denen der Grundkörper selektiv beschichtet ist,
Fig. 3 eine Anordnung mit drei elektrischen Durchführungen, bei denen sowohl Grundkörper als auch die Leiter beschichtet sind,
Fig. 4 eine Anordnung mit einer Durchführung und selektiv beschichteten Leiter,
Fig. 5 eine Anordnung mit einer elektrischen Durchführung und selektiv beschichtetem Leiter, und
Fig. 6 eine Anordnung mit einer elektrischen Durchführung mit einem selektiv beschichteten Leiter und einem zusätzlichen Masseleiter.

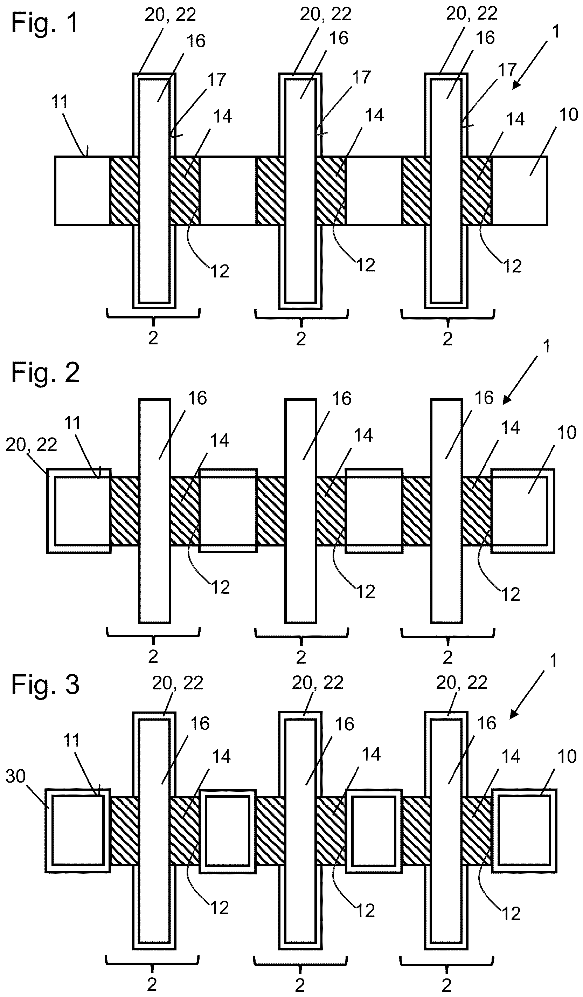

Figur 1 zeigt ein erstes Beispiel für eine Anordnung 1 mit in diesem Beispiel drei elektrischen Durchführungen 2 in einer schematischen Schnittdarstellung von der Seite. Die elektrischen Durchführungen 2 weisen einen gemeinsamen Grundkörper 10 auf, welcher für jede der elektrischen Durchführungen 2 jeweils eine Öffnung 12 aufweist. Durch jede der Öffnungen 12 ist jeweils ein elektrischer Leiter 16 hindurchgeführt. Die Leiter 16 sind jeweils in einem Fixiermaterial 14 eingebettet, welches den jeweiligen Leiter 16 hält und elektrisch gegen den Grundkörper 10 isoliert.

In dem in Figur 1 dargestellten Beispiel ist die nicht vom Fixiermaterial 14 bedeckte Oberfläche 17 der Leiter 16 mit einer ersten Beschichtung 20 versehen. Diese erste Beschichtung 20 wurde nach dem Bilden der elektrischen Durchführungen 2 selektiv auf die Leiter 16 aufgebracht. Entsprechend ist der von dem Fixiermaterial 14 bedeckte Teil der Oberfläche der Leiter 16 frei von der ersten Beschichtung 20. Da die erste Beschichtung 20 selektiv aufgebracht wurde, wurde nur das Material der Leiter 16 beschichtet. Entsprechend ist die Oberfläche 11 des Grundkörpers 10 frei von der ersten Beschichtung 20.

Die erste Beschichtung 20 weist in dem in Figur 1 skizzierten Beispiel eine einzige Schicht auf, die damit auch die äußerste Schicht 22 ist. Diese äußerste Schicht 22 wurde außenstromlos auf die Oberfläche 17 der Leiter 16 aufgebracht. Durch das außenstromlose Beschichten weist die Beschichtung 20 bzw. die äußerste Schicht 22 der ersten Beschichtung 20 über die gesamte beschichte Oberfläche der Leiter 16 keine Erhöhung der Schichtstärke an Kanten wie den Enden der Leiter 16 auf. Da zudem kein elektrischer Anschluss für ein galvanisches Beschichten vorgenommen werden musste, ist die erste Beschichtung 20 zudem vollständig geschlossen und weist vorteilhafterweise keine Fehlstellen auf.

In dem skizzierten Beispiel handelt es sich bei der ersten Beschichtung 20 bzw. der äußersten Schicht 22 beispielsweise um eine Nickel-Phosphor-Schicht oder Gold-Schicht. Für das außenstromlose Beschichten der Oberfläche 17 der Leiter 16 wurde das Material der Leiter 16 so ausgewählt, dass dieses außenstromlos beschichtbar ist. In dem skizzierten Beispiel bestehen die Leiter 16 aus NiFe45.

Die Oberfläche 11 des Grundkörpers 10 ist hingegen frei von der ersten Beschichtung 20, da das Material des Grundkörpers 10 so ausgewählt wurde, dass dieses nicht außenstromlos beschichtbar ist. In dem skizzierten Beispiel besteht der Grundkörper 10 aus einem nichtrostenden Stahl, der eine Passivschicht an seiner Oberfläche ausbildet, und entsprechend nicht außenstromlos mit der Nickel-Phosphor-Schicht bzw. Gold-Schicht beschichtet werden kann.

In dem in Figur 1 gezeigten Beispiel bestehen alle drei elektrischen Leiter 16 aus demselben Material, welches außenstromlos beschichtbar ist. Alternativ dazu ist es denkbar, einen oder mehrere Leiter 16 aus einem anderen Material zu wählen, welches nicht außenstromlos beschichtbar ist, oder mit einer zweiten Beschichtung 30 zu versehen, vergleiche Figur 3, welche nicht außenstromlos beschichtbar ist. Hierdurch kann erreicht werden, dass selektiv nur ausgewählte Leiter 16 mit der ersten Beschichtung 20 versehen werden und andere, nicht ausgewählte Leiter 16 frei von der ersten Beschichtung 20 bleiben.

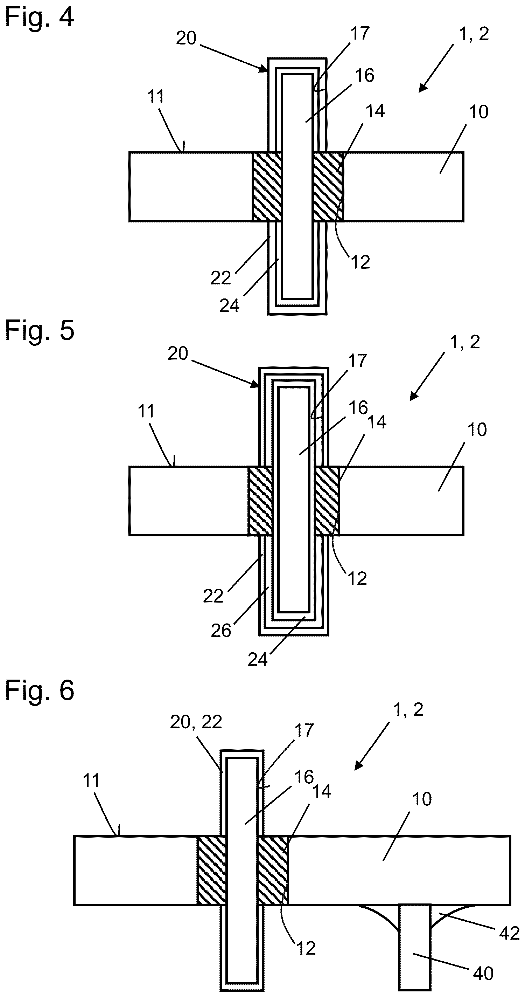

In dem skizzierten Beispiel weist die erste Beschichtung 20 nur eine einzige Schicht auf, welche entsprechend auch die äußerste Schicht 22 ist. Durch Wiederholen des Beschichtungsvorgangs mit anderen Beschichtungslösungen können weitere Schichten aufgebracht werden. In dem nachfolgend mit Bezug zur Figur 4 beschriebenen Beispiel weist die erste Beschichtung 20 zwei Schichten auf. Unter der äußersten Schicht 22 ist zusätzlich eine Zwischenschicht 24 angeordnet. In dem mit Bezug zur Figur 5 beschriebenen Beispiel weist die erste Beschichtung 20 drei Schichten auf. Ausgehend von der äußersten Schicht 22 sind in dieser Reihenfolge die äußerste Schicht 22, eine weitere Zwischenschicht 26 und eine Zwischenschicht 24 angeordnet. In weiteren Ausführungsformen wäre es zudem denkbar, mehr als drei Schichten vorzusehen, beispielsweise vier oder fünf Schichten.

Figur 2 zeigt in einer schematischen Schnittdarstellung von der Seite ein zweites Beispiel für eine Anordnung 1 mit in diesem Beispiel drei elektrischen Durchführungen 2. Wie bereits mit Bezug zur Figur 1 beschrieben weisen die elektrischen Durchführungen 2 einen gemeinsamen Grundkörper 10 auf, welcher für jede der elektrischen Durchführungen 2 jeweils eine Öffnung 12 aufweist. Durch jede der Öffnungen 12 ist jeweils ein elektrischer Leiter 16 hindurchgeführt. Die Leiter 16 sind jeweils in einem Fixiermaterial 14 eingebettet, welches den jeweiligen Leiter 16 hält und elektrisch gegen den Grundkörper 10 isoliert.

In dem in Figur 2 dargestellten Beispiel ist die nicht vom Fixiermaterial 14 bedeckte Oberfläche 11 des Grundkörpers 10 mit einer ersten Beschichtung 20 versehen. Diese erste Beschichtung 20 wurde nach dem Bilden der elektrischen Durchführungen 2 selektiv auf den Grundkörper 10 aufgebracht. Entsprechend ist der von dem Fixiermaterial 14 bedeckte Teil der Oberfläche des Grundkörpers 10 frei von der ersten Beschichtung 20. Da die erste Beschichtung 20 selektiv aufgebracht wurde, wurde nur das Material des Grundkörpers 10 beschichtet. Entsprechend ist die Oberfläche 17 der Leiter 16 frei von der ersten Beschichtung 20.

Die erste Beschichtung 20 weist, wie in dem mit Bezug zur Figur 1 beschriebenen Beispiel, eine einzige Schicht auf, die äußerste Schicht 22, welche außenstromlos auf die Oberfläche 11 des Grundkörpers 10 aufgebracht wurde. Durch das außenstromlose Beschichten weist die erste Beschichtung 20 bzw. die äußerste Schicht 22 der ersten Beschichtung 20 eine über die gesamte beschichte Oberfläche des Grundkörpers 10 keine Erhöhung der Schichtstärke an Kanten auf. Da zudem kein elektrischer Anschluss für ein galvanisches Beschichten vorgenommen werden musste, ist die erste Beschichtung 20 zudem vollständig geschlossen und weist vorteilhafterweise keine Fehlstellen auf.

Bei der äußersten Schicht 22 der ersten Beschichtung 20 kann es sich beispielsweise wieder um eine Nickel-Phosphorschicht handeln. Als Material des Grundkörpers wurde in diesem Beispiel ein Stahl ausgewählt, der keine Passivschicht ausbildet, und entsprechend außenstromlos mit der Nickel-Phosphorschicht beschichtbar ist. Das Material der Leiter 16 hingegen ist beispielsweise ein nichtrostender Stahl, der eine Passivschicht ausbildet, und somit nicht außenstromlos beschichtbar ist. Entsprechend ist die Oberfläche 17 der Leiter 16 frei von der ersten Beschichtung 20.

Figur 3 zeigt schematisch ein drittes Beispiel für eine Anordnung 1 mit in diesem Beispiel drei elektrischen Durchführungen 2. Der Aufbau der Anordnung 1 entspricht dem ersten Beispiel, welches mit Bezug zu Figur 1 beschrieben wurde. Abweichend von dem ersten Beispiel ist die Oberfläche 11 des Grundkörpers 10 nicht frei von jeglichen Beschichtungen, sondern ist mit einer zweiten Beschichtung 30 versehen, welche von der ersten Beschichtung 20 verschieden ist. In dem in Figur 3 dargestellten Beispiel wurde die zweite Beschichtung 30 vor dem Bilden der Anordnung 1 auf die Oberfläche 11 des Grundkörpers 10 aufgebracht, so dass die zweite Beschichtung 30 die gesamte Oberfläche 11 überdeckt, auch den Teil der Oberfläche 11 des Grundkörpers 10, der an das Fixiermaterial 14 angrenzt. Alternativ ist es aber auch denkbar, dass die zweite Beschichtung 30 die Oberfläche 11 des Grundkörpers 10 nicht vollständig überdeckt.

Die zweite Beschichtung 30 kann eine oder mehrere Schichten aufweisen. In dem in Figur 3 skizzierten Beispiel weist die zweite Beschichtung 30 genau eine Schicht auf, welche entsprechend auch die äußerste Schicht der zweiten Beschichtung 30 bildet. Die zweite Beschichtung 30 bzw. die äußerste Schicht der zweiten Beschichtung 30 besteht aus einem zweiten Beschichtungsmaterial, welches so ausgewählt ist, dass dieses nicht außenstromlos beschichtbar ist. Entsprechend ist es bei dem in Figur 3 gezeigtem Beispiel möglich, dass der Grundkörper 10 aus demselben Material wie die elektrischen Leiter 16 besteht oder aus einem ersten Metallmaterial besteht, welches mit dem ersten Beschichtungsmaterial beschichtbar ist. Ein selektives Beschichten ist jedoch weiterhin möglich, da das Material des Grundkörpers 10 durch die zweite Beschichtung 30 abgedeckt ist.

Figur 4 zeigt schematisch ein viertes Beispiel für eine Anordnung 1 mit in diesem Beispiel einer einzigen elektrischen Durchführung 2. Die elektrische Durchführung 2 weist einen Grundkörper 10 mit einer Öffnung 12 auf. Ein Leiter 16 ist durch die Öffnung 12 hindurchgeführt und in einem Fixiermaterial 14 eingebettet, welches den Leiter 16 hält und elektrisch gegen den Grundkörper 10 isoliert.

In dem in Figur 4 dargestellten Beispiel weist die erste Beschichtung 20 genau zwei Schichten auf. Ausgehend von der Oberfläche 17 des Leiters 16 weist die erste Beschichtung 20 in dieser Reihenfolge eine Zwischenschicht 24 und eine äußerste Schicht 22 auf. Beide Schichten, also die Zwischenschicht 24 und die äußerste Schicht 22, können außenstromlos abgeschieden worden sein. In dem in Figur 4 skizzierten Beispiel wurden die Zwischenschicht 24 und die äußerste Schicht 22 beide nach dem Ausbilden der elektrischen Durchführung 2 aufgebracht, so dass beide Schichten lediglich den Teil der Oberfläche 17 des Leiters 16 bedecken, der nicht von dem Fixiermaterial 14 überdeckt ist.

Des Weiteren ist es denkbar, dass lediglich die äußerste Schicht 22 außenstromlos abgeschieden wird und die Zwischenschicht 24 mittels eines anderen Verfahrens, also beispielsweise galvanisch, aufgebracht wird. Wird dabei die Zwischenschicht 24 vor dem Ausbilden der elektrischen Durchführung 2 aufgebracht, so würde in diesem Fall die Zwischenschicht 24 im Gegensatz zu der äußersten Schicht 22 die gesamte Oberfläche 17 des Leiters 16, also auch den von dem Fixiermaterial 14 überdeckten Teil des Leiters 16 bedecken.

Bei der Zwischenschicht 24 kann es sich beispielsweise um eine Nickel-Phosphor-Schicht und bei der äußersten Schicht 22 kann es sich um eine Goldschicht handeln.

Figur 5 zeigt schematisch ein fünftes Beispiel für eine Anordnung 1 mit in diesem Beispiel einer einzigen elektrischen Durchführung 2. Das fünfte Beispiel entspricht im Wesentlichen dem mit Bezug zur Figur 4 beschriebenen vierten Beispiel, jedoch ist die erste Beschichtung 20 hier mit genau drei Schichten ausgeführt. Die erste Beschichtung 20 weist ausgehend von der Oberfläche 17 des elektrischen Leiters 16 eine Zwischenschicht 24, eine weitere Zwischenschicht 26 und eine äußerste Schicht 22 auf.

Bei der Zwischenschicht 24 kann es sich beispielsweise um eine Nickel-Schicht handeln. Bei der weiteren Zwischenschicht 26 kann es sich um eine Palladiumschicht und bei der äußersten Schicht 22 kann es sich um eine Goldschicht handeln.

In dem in Figur 5 skizzierten Beispiel wurde die Zwischenschicht 24 vor dem Ausbilden der elektrischen Durchführung 2 auf den elektrischen Leiter 16 aufgebracht und überdeckt deswegen den elektrischen Leiter 16 vollständig. Nach dem Ausbilden der elektrischen Durchführung 2 wurden erst eine weitere Zwischenschicht 26 und zuletzt die äußerste Schicht 22 aufgebracht. Die weitere Zwischenschicht 26 und die äußere Schicht 22 können beide außenstromlos abgeschieden sein. Die Zwischenschicht 24 kann insbesondere eine Nickel-Schicht sein, die beispielsweise galvanisch aufgebracht wurde.

In dem in Figur 5 skizzierten Beispiel sind die weitere Zwischenschicht 26 und die äußerste Schicht 22 beide außenstromlos abgeschieden. Es ist aber auch denkbar, dass die weitere Zwischenschicht 26 mittels eines anderen Verfahrens aufgebracht wird, beispielsweise über ein galvanisches Beschichtungsverfahren, und lediglich die äußerste Schicht 22 außenstromlos abgeschieden wird.

Figur 6 zeigt schematisch ein sechstes Beispiel für eine Anordnung 1 mit in diesem Beispiel einer einzigen elektrischen Durchführung 2. Die elektrische Durchführung 2 weist einen Grundkörper 10 mit einer Öffnung 12 auf. Ein Leiter 16 ist durch die Öffnung 12 hindurchgeführt und in einem Fixiermaterial 14 eingebettet, welches den Leiter 16 hält und elektrisch gegen den Grundkörper 10 isoliert. In dem in Figur 6 dargestellten Beispiel weist die erste Beschichtung 20 genau eine Schicht auf, welche entsprechend auch die äußerste Schicht 22 ist.

In dem in Figur 6 dargestellten Beispiel weist die Anordnung 1 zusätzlich zu dem elektrischen Leiter 16 der elektrischen Durchführung 2 einen Masseleiter 40 auf, der elektrisch leitend mit dem Grundkörper 10 verbunden ist. Das Verbinden des Masseleiters 40 erfolgt beispielsweise unter Verwendung eines Lotmaterials 42. Es ist aber auch denkbar, den Masseleiter 40 über ein anderes Verfahren mit dem Grundkörper 10 zu verbinden, beispielsweise durch Schweißen.

Der Masseleiter 40 besteht in dem skizzierten sechsten Beispiel aus demselben Material wie der Grundkörper 10 oder besteht aus einem davon abweichenden Material, welches aber ebenfalls nicht außenstromlos beschichtbar ist. Entsprechend ist der Masseleiter 40 wie auch der Grundkörper 10 hier frei von der ersten Beschichtung 20.

Obwohl die vorliegende Erfindung anhand bevorzugter Ausführungsbeispiele beschrieben wurde, ist sie nicht darauf beschränkt, sondern auf vielfältige Weise modifizierbar.

### Bezugszeichenliste

- 1: Anordnung
- 2: elektrische Durchführung

- 10: Grundkörper
- 11: Oberfläche Grundkörper
- 12: Öffnung
- 14: Fixiermaterial
- 16: Leiter
- 17: Oberfläche Leiter

- 20: erste Beschichtung
- 22: äußerste Schicht
- 24: Zwischenschicht
- 26: weitere Zwischenschicht

- 30: zweite Beschichtung

- 40: Masseleiter
- 42: Lotmaterial

## Patentansprüche

1. Anordnung (1) mit zumindest einer elektrischen Durchführung (2) umfassend einen Grundkörper (10) mit einer Öffnung (12), durch die ein elektrischer Leiter (16) hindurchgeführt ist und über ein Fixiermaterial (14) elektrisch isoliert vom Grundkörper (10) in der Öffnung (12) gehalten ist, wobei das Fixiermaterial (14) die Öffnung (12) verschließt, wobei sowohl der elektrische Leiter (16) als auch der Grundkörper (10) metallische Komponenten sind und wobei die nicht vom Fixiermaterial (14) bedeckte Oberfläche des elektrischen Leiters (16) vollständig mit einer ersten Beschichtung (20) versehen ist, die vom Fixiermaterial (14) bedeckte Oberfläche des elektrischen Leiters (16) frei von der ersten Beschichtung (20) ist und die nicht vom Fixiermaterial (14) bedeckte Oberfläche des Grundkörpers (10) frei von der ersten Beschichtung (20) ist und optional mit einer zweiten Beschichtung (30) versehen ist, welche von der ersten Beschichtung (20) verschieden ist, oder
die nicht vom Fixiermaterial (14) bedeckte Oberfläche des Grundkörpers (10) vollständig mit der ersten Beschichtung (20) versehen ist, die vom Fixiermaterial (14) bedeckte Oberfläche des Grundkörpers (10) frei von der ersten Beschichtung (20) ist und die nicht vom Fixiermaterial (14) bedeckte Oberfläche des elektrischen Leiters (16) frei von der ersten Beschichtung ist (20) und optional mit einer zweiten Beschichtung (30) versehen ist, welche von der ersten Beschichtung (20) verschieden ist,
**dadurch gekennzeichnet, dass** die erste Beschichtung (20) eine oder mehrere Schichten aufweist und zumindest eine äußerste Schicht (22) der ersten Beschichtung (20) eine außenstromlos abgeschiedene Schicht aus einem ersten Beschichtungsmaterial ist.

2. Anordnung (1) gemäß Anspruch 1, **dadurch gekennzeichnet, dass** die äußerste Schicht (22) der ersten Beschichtung (20) eine von der Geometrie der beschichteten Komponente unabhängige Schichtstärke aufweist, wobei die Schichtstärke der äußersten Schicht (22) bevorzugt über die gesamte beschichtete Oberfläche konstant ist.

3. Anordnung (1) gemäß Anspruch 1 oder 2, **dadurch gekennzeichnet, dass** der mit der ersten Beschichtung (20) versehene elektrische Leiter (16) oder der mit der ersten Beschichtung (20) versehene Grundkörper (10) aus einem ersten Metallmaterial besteht, welches außenstromlos mit dem ersten Beschichtungsmaterial (20) beschichtbar ist, oder eine Zwischenschicht (24, 26) aufweist, die aus dem ersten Metallmaterial besteht, welches außenstromlos mit dem ersten Beschichtungsmaterial beschichtbar ist.

4. Anordnung (1) gemäß Anspruch 3, **dadurch gekennzeichnet, dass** das erste Metallmaterial ausgewählt ist aus der Gruppe Ag, Ag-Legierungen, Cu, Cu-Legierungen, Ni, Ni-Legierungen, welche frei von Oberflächenoxiden sind, welche nicht mit dem ersten Beschichtungsmaterial beschichtbar sind, Platinmetalle und Platinmetalllegierungen, Fe, Stähle, welche frei von Oberflächenoxiden sind, welche nicht mit dem ersten Beschichtungsmaterial beschichtbar sind Co und Co-Legierungen, welche frei von Oberflächenoxiden sind, welche nicht mit dem ersten Beschichtungsmaterial beschichtbar sind, Mn und Mn-Legierungen, welche frei von Oberflächenoxiden sind, welche nicht mit dem ersten Beschichtungsmaterial beschichtbar sind, Zn, Zn-Legierungen, Sn, Sn-Legierungen.

5. Anordnung (1) gemäß einem der Ansprüche 1 bis 4, **dadurch gekennzeichnet, dass** der von der ersten Beschichtung (20) freie Grundkörper (10) oder der von der ersten Beschichtung (20) freie elektrische Leiter (16) aus einem zweiten Metallmaterial besteht, welches nicht außenstromlos mit dem ersten Beschichtungsmaterial beschichtbar ist oder die zweite Beschichtung (30) eine äußerste Schicht aus dem zweiten Metallmaterial aufweist, welches nicht außenstromlos mit dem ersten Beschichtungsmaterial beschichtbar ist.

6. Anordnung (1) gemäß Anspruch 5, **dadurch gekennzeichnet, dass** das zweite Metallmaterial ausgewählt ist aus der Gruppe Stähle mit ausgebildeten Oberflächenoxiden, welche nicht mit dem ersten Beschichtungsmaterial beschichtbar sind, Nickellegierungen mit ausgebildeten Oberflächenoxiden, welche nicht mit dem ersten Beschichtungsmaterial beschichtbar sind, insbesondere Nickellegierungen mit Mo, Cu und/oder Cr, Ti, Mo, W, Al, Nb, Cr, Zr, Hf, V, Ta und deren Legierungen.

7. Anordnung (1) gemäß einem der Ansprüche 1 bis 6, **dadurch gekennzeichnet, dass** das erste Beschichtungsmaterial ausgewählt ist aus Nickel mit Anteilen an Phosphor (NiP), Nickel mit Anteilen an Bor (NiB), Ni, Cu, Ag, Sn, Palladium mit Anteil an Phosphor (PdP), Pd, Au.

8. Anordnung (1) gemäß einem der Ansprüche 1 bis 7, **dadurch gekennzeichnet, dass** die erste Beschichtung (20) genau zwei Schichten aufweist, wobei die äußerste Schicht (22) außenstromlos abgeschiedenes Gold (Au) ist und eine Zwischenschicht (24) NiP ist.

9. Anordnung (1) gemäß einem der Ansprüche 1 bis 7, **dadurch gekennzeichnet, dass** die erste Beschichtung (20) genau drei Schichten aufweist, wobei die äußerste Schicht (22) außenstromlos abgeschiedenes Gold ist, eine Zwischenschicht (24) außenstromlos abgeschiedenes NiP ist und eine weitere Zwischenschicht (26) Palladium-Phosphor ist.

10. Verfahren zur Herstellung einer Anordnung (1) gemäß einem der Ansprüche 1 bis 9, umfassend die Schritte
- Bereitstellen eines elektrischen Leiters (16), der an seiner Oberfläche ein erstes Metallmaterial aufweist oder der aus dem ersten Metallmaterial besteht und Bereitstellen eines Grundkörpers (10) mit einer Öffnung (12), der an seiner Oberfläche ein zweites Metallmaterial aufweist oder aus dem zweiten Metallmaterial besteht, oder Bereitstellen eines Grundkörpers (10) mit einer Öffnung (12), der an seiner Oberfläche ein erstes Metallmaterial aufweist oder aus dem ersten Metallmaterial besteht und Bereitstellen eines elektrischen Leiters (16), der an seiner Oberfläche ein zweites Metallmaterial aufweist oder aus dem zweiten Metallmaterial besteht,
- Bereitstellen eines Fixiermaterialrohlings,
- Einsetzen des elektrischen Leiters (16) und des Fixiermaterialrohlings in die Öffnung (12),
- Einbetten des elektrischen Leiters (16) und Ausbilden des Fixiermaterials (14) durch eine Temperaturbehandlung zum Erhalten einer Rohanordnung,
- außenstromloses Abscheiden einer Schicht aus einem ersten Beschichtungsmaterial auf freiliegende Oberflächen des elektrischen Leiters (16) oder auf freiliegende Oberflächen des Grundkörpers (10) durch Eintauchen der Rohanordnung in eine Beschichtungslösung,
- optional außenstromloses Abscheiden einer oder mehrerer weiterer Schichten auf den elektrischen Leiter (16) oder auf den Grundkörper (10) durch Eintauchen der Rohanordnung in eine oder mehrere weitere Beschichtungslösungen.
